# EUROPEAN PATENT APPLICATION

(11) **EP 3 637 967 A1**
(43) Date of publication of application: **15.04.2020**
(21) Application number: 18813996.8
(22) Date of filing: 06.06.2018
(51) Int. Cl.: H05K 7/00

(54) **ELECTRIC DEVICE**

(30) Priority: 09.06.2017 JP 2017114226
(71) Applicant: Kawasaki Jukogyo Kabushiki Kaisha, Kobe-shi, Hyogo 650-8670 (JP)
(72) Inventor: TAGASHIRA, Tsuyoshi, Hyogo 6508670 (JP); KATO, Tomoki, Hyogo 6508670 (JP)
(74) Representative: Luten, Martin Haaije
(86) International application number: PCT/JP2018/021668
(87) International publication number: WO 2018/225771

(57) **Abstract**

An electric device (10) includes: a body that accommodates an electric component; a lid that covers an open portion of the body; a first seal portion (71) provided on the body; a second seal portion (61) provided on the lid, in which a first groove (72) which is recessed from the open portion and into which a cable (38) of the electric component is fitted is formed in the first seal portion (71), in which a second groove (62) which faces the first groove (72) and into which the cable (38) is fitted is formed in the second seal portion (61), and in which a housing formed by the body and the lid is provided with an insertion portion through which the cable of the electric component extending from an inside of the housing to an outside passes and which corresponds to the first groove and the second groove.

## Description

### Technical Field

The present invention relates to an electric device, and, for example, relates to an electric device including a housing that accommodates an electric component to which a cable is connected.

### Background Art

For example, an electronic device accommodation rack shown in Patent Literature 1 is known as one that secures sealing performance in an electric device that includes a housing that accommodates an electric component to which a cable is connected. In this electronic device accommodation rack, a slit for drawing a cable from the inside of a rack body to the outside is provided in a plate-like lid made of an elastic material.

### Citation List

### Patent Literature

PTL 1: JP 2008-153591 A

### Summary of Invention

### Technical Problem

For example, when a cable is connected to an electronic device attached in advance to a rack or the like, a cable having a connector for connecting to the electronic device at one end and a connector for connecting to an external power source at the other end is used. In this case, in the electronic device accommodation rack shown in Patent Literature 1, since the cable is inserted into the slit of the lid and pulled out, it is necessary to provide, in the lid, a large slit for allowing a connector larger than the cable to pass. Therefore, it is not easy to secure sealing performance.

The present invention has been made to solve such a problem, and an object of the present invention is to provide an electric device that can easily secure sealing performance.

### Solution to Problem

According to one mode of the present invention, there is provided an electric device including: a body that accommodates an electric component; a lid that covers an open portion of the body; a first seal portion provided on the body; a second seal portion provided on the lid, in which a first groove which is recessed from the open portion and into which a cable of the electric component is fitted is formed in the first seal portion, in which a second groove which faces the first groove and into which the cable is fitted is formed in the second seal portion, and in which a housing formed by the body and the lid is provided with an insertion portion through which the cable of the electric component extending from an inside of the housing to an outside passes and which corresponds to the first groove and the second groove.

In the electric device, the insertion portion may be formed by the body and the lid that covers the open portion.

In the electric device, the first groove may be formed in an arc shape whose central angle is larger than 180 degrees and radius is smaller than a radius of the cable.

In the electric device, the first seal portion and the second seal portion may be formed of an elastic member, and be compressed against each other when the open portion is covered by the lid.

In the electric device, the first groove and the second groove may form a circular shape by the first seal portion and the second seal portion compressed against each other.

The electric device may further include: a first outer support portion in which a first outer groove that surrounds the first groove is formed and which is stacked on an outer side with respect to the first seal portion and is harder than the first seal portion; and a second outer support portion in which a second outer groove that surrounds the second groove is formed and which is stacked on an outer side with respect to the second seal portion and is harder than the second seal portion.

The electric device may further include: a first inner support portion in which a first inner groove that surrounds the first groove is formed and which is stacked on an inner side with respect to the first seal portion and is harder than the first seal portion; and a second inner support portion in which a second inner groove that surrounds the second groove is formed and which is stacked on an inner side with respect to the second seal portion and is harder than the second seal portion.

In the electric device, the open portion may be opened in a direction in which the first groove extends and in a direction in which the first groove is opened which is opposite to a direction in which the first groove is recessed.

In the electric device, a plurality of first grooves may be provided side by side in one first seal portion along a boundary between the body and the lid, and a plurality of second grooves may face the first grooves and be provided side by side in the second seal portion.

### Advantageous Effects of Invention

The present invention has an effect that it has above-described configurations and can provide an electric device that can easily secure sealing performance.

The above object, other objects, features, and advantages of the present invention will become apparent from the following detailed description of a preferred embodiment with reference to the accompanying drawings.

### Brief Description of Drawings

Fig. 1 is a perspective view showing an electric device according to an embodiment of the present invention.
Fig. 2 is a cross-sectional view of the electric device of Fig. 1.
Fig. 3 is a cross-sectional view of the electric device when a first cover, a second cover, and a third cover are attached to a body of Fig. 1.
Fig. 4 is a cross-sectional view of the electric device when a third-a cover portion of Fig. 3 is removed.
Fig. 5 is a view of the electric device of Fig. 4 as viewed from the rear side.
Fig. 6 is a view of the electric device of Fig. 3 as viewed from the rear side.

### Description of Embodiments

Now, embodiments of the present invention are specifically described with reference to the drawings. Note that, in the followings, the same or corresponding elements are denoted by the same reference symbols throughout all the drawings, and redundant description thereof is omitted. Moreover, in each of the drawings, directions of up, down, left, right, front, and rear are defined, but the direction of an electric device is not limited to this.

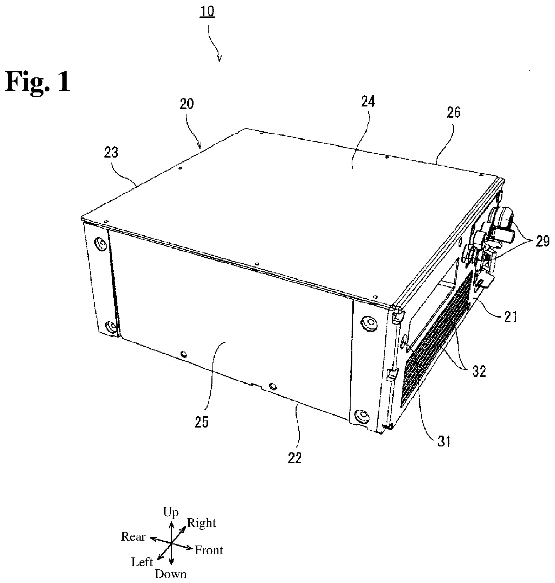

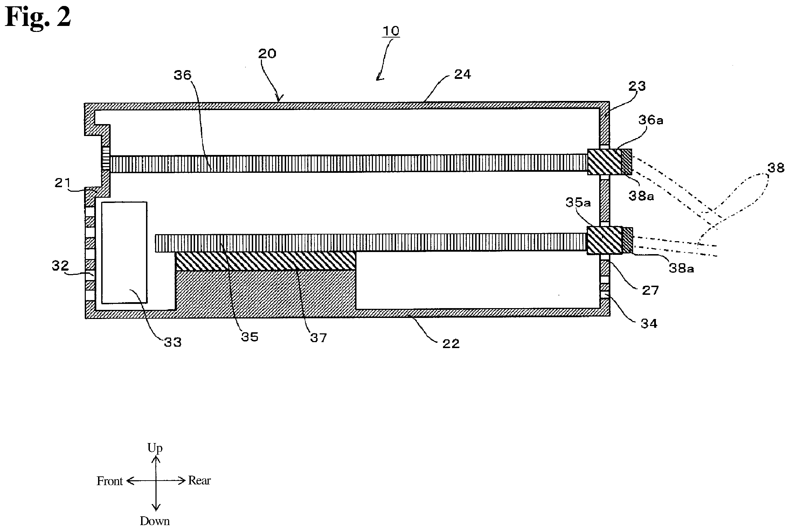

The configuration of an electric device 10 according to an embodiment will be described with reference to Figs. 1 to 2. The electric device 10 includes a case 20 that accommodates electric components. The case 20 is made of, for example, a material having better thermal conductivity than iron, and examples of this material include metal such as aluminum. The case 20 is a case 20 having an internal space, and has a rectangular parallelepiped shape, for example. The case 20 has a front wall 21, a lower wall 22, a rear wall 23, an upper wall 24, a left wall 25, and a right wall 26.

The case 20 is provided with a plurality of first vent holes 32. Further, a plurality of first fans 33 are provided in the case 20, and are arranged at intervals in the rightward and leftward direction. The first fans 33 are provided in the vicinity of the first vent holes 32 in the front wall 21 so as to face the first vent holes 32 and are arranged at a position overlapping the first vent holes 32 in a plan view from the front to the rear. Thereby, the first fans 33 introduce air from the first vent holes 32 on the front side and blow it rearward.

A plurality of third vent holes 34 are opened in the rear wall 23. The third vent holes 34 are arranged at a position overlapping the first vent holes 32 in the front wall 21 in a plan view from the front to the rear. The first fans 33 are arranged between the third vent holes 34 and the first vent holes 32. As a result, a first flow path in which air introduced from the first vent holes 32 by the first fans 33 flows rearward and is exhausted from the third vent holes 34 is provided in the case 20.

The case 20 accommodates a plurality of electric components. Examples of the electric components include a power semiconductor element 37, a power circuit board 35 on which the power semiconductor element 37 is mounted, a control circuit board 36, a regenerative resistor, and the like. Among these, components such as the power semiconductor element 37 and the regenerative resistor that generate more heat than other electric components such as the control circuit board 36 are arranged in contact with the inner surface of the lower wall 22. Thereby, the heat generated from these is transferred to the case 20 having a good thermal conductivity, so that the electrical components are dissipated and cooled.

In addition, components such as the power semiconductor element 37 and the regenerative resistor that generate more heat are arranged in the first flow path by the first fans 33 between the first vent holes 32 and the third vent holes 34. Thus, these electrical components are cooled by the air blown by the first fans 33.

The rear wall 23 is provided with a plurality of through holes 27, and the internal space of the case 20 communicates with the outside through the through holes 27. A connector 35a of the power circuit board 35 and a connector 36a of the control circuit board 36 are communicated with each through hole 27. A connector 38a provided at one end of a cable 38 is connected to the connectors 35a and 36a. A connector (not shown) for connecting to an external power source is provided to the other end of the cable 38.

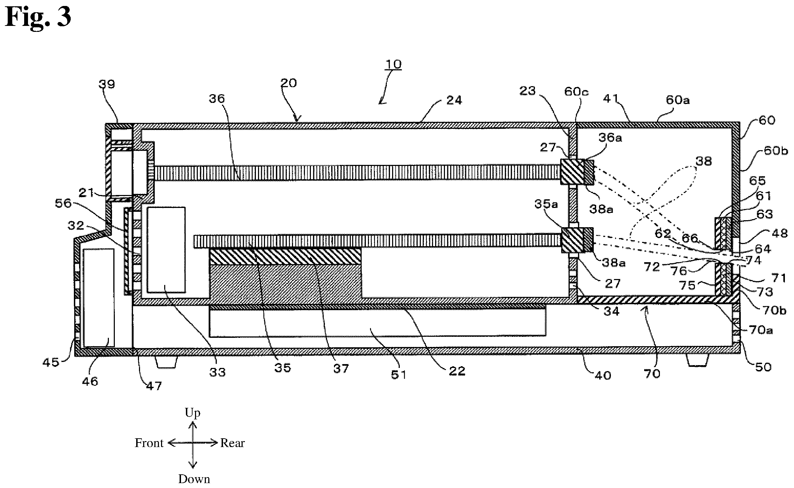

Next, the electric device 10 for sealing the case 20 will be described with reference to Fig. 3. A first cover 39 is attached to the outer surface of the front wall 21 of the case 20, a second cover 40 is attached to the outer surface of the lower wall 22, and a third cover 41 is attached to the outer surface of the rear wall 23. The first cover 39, the second cover 40, and the third cover 41 are made of, for example, a material having better thermal conductivity than iron, and examples of this material include aluminum.

The first cover 39 has a shape with a rear opening, and covers the first vent holes 32 in the front wall 21. The first cover 39 is provided with a plurality of second vent holes 45. A second fan 46 is provided in the first cover 39 so as to face the second vent holes 45.

The second fan 46 is covered by the first cover 39 and is arranged at a position overlapping the second vent holes 45 in the first cover 39 in a plan view from the front to the rear. Thereby, the second fan 46 introduces external air from the second vent holes 45 on the front side and blows it rearward.

In the first cover 39, a covering component 56 is attached to the outer surface of the front wall 21 so as to close the first vent holes 32 in the front wall 21. The covering component 56 has, for example, a flat plate shape, closes the first vent holes 32, and seals the case 20 at the front wall 21.

The covering component 56 is arranged to face the second fan 46, and the air introduced by the second fan 46 through the second vent holes 45 is sent to the covering component 56. The covering component 56 is made of, for example, a material having better thermal conductivity than iron, and examples of this material include aluminum. For this reason, the covering component 56 and the air in the vicinity thereof are cooled by the air sent by the second fan 46. Since the covering component 56 is located on the upstream side of the first fans 33, the first fans 33 can send the air cooled by the covering component 56 to heat-generating components and efficiently cool them.

The second cover 40 has a rectangular parallelepiped shape with an upper opening, and is provided below the case 20 and the third cover 41. The second cover 40 covers the lower wall 22 of the case 20 and the lower surface of the third cover 41 and forms a closed space between the second cover 40 and the lower wall 22 of the case 20 and the lower surface of the third cover 41. The length of the second cover 40 in the forward and rearward direction is equal to the sum of the length of the case 20 and the length of the third cover 41, and the second cover 40 extends over the lower wall 22 and the third cover 41 in the forward and rearward direction.

The second cover 40 also opens forward and is provided with an opening 47. The second fan 46 is arranged in front of the opening 47, and the opening 47 is covered by the first cover 39. Through this opening 47, the internal space of the first cover 39 and the internal space of the second cover 40 communicate with each other. Therefore, the air introduced from the second vent holes 45 by the second fan 46 is blown into the second cover 40 through the opening 47.

Further, a plurality of fourth vent holes 50 are opened in the rear surface of the second cover 40. The fourth vent holes 50 are arranged at a position overlapping the opening 47 and the second vent holes 45 in the first cover 39 in a plan view from the front to the rear, and the second fan 46 is arranged between the fourth vent holes 50 and the second vent holes 45. As a result, a second flow path in which air introduced from the second vent holes 45 by the second fan 46 flows rearward and is exhausted from the fourth vent holes 50 through the opening 47 is provided in the second cover 40.

On the inner side of the second cover 40, a heat sink 51 is attached to the outer surface of the lower wall 22 of the case 20 (lower surface of the case 20). The heat sink 51 is detachably attached to the case 20 with a screw or the like, covered by the second cover 40, and arranged in the second flow path by the second fan 46. The heat-generating components (power semiconductor element 37 and regenerative resistor) are cooled by the heat sink 51 through the lower wall 22.

The third cover 41 has a rectangular parallelepiped shape with a front opening, covers the rear surface of the rear wall 23 of the case 20, and forms a closed space between the third cover 41 and the rear wall 23 of the case 20. The third cover 41 has a height in the upward and downward direction equal to the height of the case 20 in the upward and downward direction, and extends over the outer surface of the rear wall 23 of the case 20 in the upward and downward direction. The shape in which the case 20 is covered by the second cover 40 and the third cover 41 is a rectangular parallelepiped shape.

The third cover 41 is provided with an insertion portion 48. A cable 38 or the like is inserted into the insertion portion 48. The cable 38 is, for example, a cable for supplying power to be connected to an external power source such as a commercial power source, and a cable for connecting electric components such as boards to an external device.

Next, details of the third cover 41 will be described with reference to Figs. 3 to 5. The third cover 41 includes a third-a cover portion 60 and a third-b cover portion 70. The third-a cover portion 60 has an upper surface portion 60a and an upper portion of the rear surface portion (third-a rear surface portion 60b) of the third cover 41, and the third-b cover portion 70 has a right surface portion, a left surface portion, a lower surface portion 70a, and a lower portion of the rear surface portion (third-b rear surface portion 70b) of the third cover 41. Note that the third-a cover portion 60 may have the right surface portion and/or the left surface portion of the third cover 41 in place of the third-b cover portion 70.

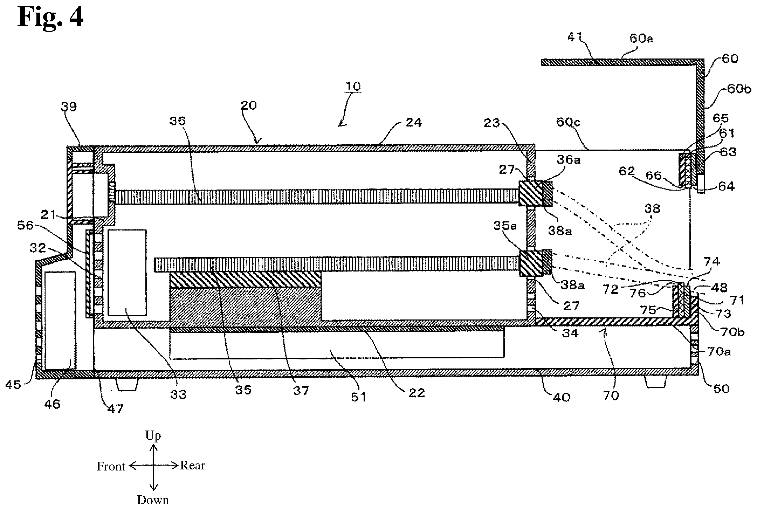

As shown in Figs. 3 and 4, the third-a cover portion 60 is detachable from the third-b cover portion 70. As shown in Fig. 3, when the third-b cover portion 70 is attached to the case 20, the internal space of the case 20 that accommodates the electric components communicates with the internal space of the third-b cover portion 70 through the through holes 27 in the rear wall 23 of the case 20. The case 20 and the third-b cover portion 70 attached and integrated in this way function as a body that accommodates electric components.

On the other hand, as shown in Fig. 4, when the third-a cover portion 60 is removed from the third-b cover portion 70, the third-b cover portion 70 has an open portion 60c that opens at the upper and rear upper parts. Then, as shown in Fig. 3, when the third-a cover portion 60 is attached to the third-b cover portion 70, the third-a cover portion 60 covers the open portion 60c of the third-b cover portion 70. Thereby, the third-a cover portion 60 functions as a lid that covers the open portion 60c of the body.

Such a body (case 20 and third-b cover portion 70) and the lid (third-a cover portion 60) form a housing. The housing is provided with the insertion portion 48 through which the cable 38 of the electric component extending from the inside of the housing to the outside passes. The insertion portion 48 is formed by the third-b cover portion 70 and the third-a cover portion 60 that covers the open portion 60c of the third-b cover portion 70. For this reason, the insertion portion 48 is provided between the third-b cover portion 70 and the third-a cover portion 60 by covering the opening portion 60c of the third-b cover portion 70 with the third-a cover portion 60. On the other hand, by removing the third-a cover portion 60 from the third-b cover portion 70, the third-b cover portion 70 is opened by the open portion 60c.

In addition, the third-b rear surface portion 70b of the third-b cover portion 70 is provided with a recess (third-b recess 70c). The third-b recess 70c has, for example, a rectangular shape, and is recessed downward from the third-b rear surface portion 70b of the third-b cover portion 70, the upper ends of the right surface portion and the left surface portion, and the portion where the third-b cover portion 70 and the third-a cover portion 60 are in contact with each other.

Furthermore, the third-a rear surface portion 60b of the third-a cover portion 60 is provided with a recess (third-a recess 60d). The third-a recess 60d has, for example, a rectangular shape, and is recessed downward from the third-a rear surface portion 60b of the third-a cover portion 60, the upper ends of the right surface portion and the left surface portion, and the portion where the third-b cover portion 70 and the third-a cover portion 60 are in contact with each other.

The third-b recess 70c and the third-a recess 60d are arranged at positions facing each other. For this reason, when the third-a cover portion 60 is attached to the third-b cover portion 70, the insertion portion 48 is provided between the third-a cover portion 60 and the third-b cover portion 70 by the third-b recess 70c and the third-a recess 60d.

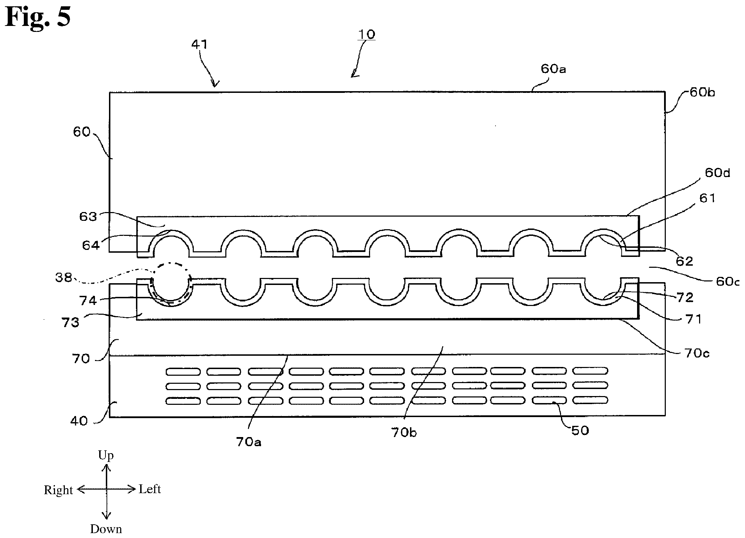

As shown in Figs. 4 and 5, a first seal portion 71 is provided on the third-b cover portion 70 (body), and a second seal portion 61 is provided on the third-a cover portion 60 (lid). The first seal portion 71 and the second seal portion 61 are made of an elastic member such as sponge and have, for example, a rectangular flat plate shape.

The first seal portion 71 is arranged on the inner side of the third-b rear surface portion 70b and extends upward from one end (upper end) of the third-b rear surface portion 70b. The other end (lower end) of the first seal portion 71 reaches, for example, the lower surface portion 70a of the third-b cover portion 70, and the lower portion of the first seal portion 71 overlaps the third-b rear surface portion 70b. The second seal portion 61 is arranged on the inner side of the third-a rear surface portion 60b and extends downward from one end (lower end) of the third-a rear surface portion 60b. The upper portion of the second seal portion 61 overlaps the third-a rear surface portion 60b.

The thickness in the forward and rearward direction of the first seal portion 71 is equal to the thickness in the forward and rearward direction of the second seal portion 61, and the width in the rightward and leftward direction of the first seal portion 71 is equal to the width in the rightward and leftward direction of the second seal portion 61. When the third-a cover portion 60 is attached to the third-b cover portion 70, the first seal portion 71 and the second seal portion 61 are arranged so that the upper end of the first seal portion 71 and the lower end of the second seal portion 61 face each other.

The first seal portion 71 is provided with first grooves 72 into which the cable 38 of the electric component is fitted. The plurality of first grooves 72 are arranged in the rightward and leftward direction at intervals from each other along the upper end of the first seal portion 71. Therefore, the plurality of first grooves 72 are arranged along the boundary between the third-b cover portion 70 (body) and the third-a cover portion 60 (lid).

The first grooves 72 are recessed from the open portion 60c of the third-b cover portion 70 and extends downward from the upper end of the first seal portion 71. The first grooves 72 extend in the thickness direction (forward and rearward direction) of the first seal portion 71 and penetrate the first seal portion 71. The first grooves 72 have a circular arc shape in a plane perpendicular to the forward and rearward direction, and have, for example, a circular arc shape whose central angle is larger than 180 degrees and larger than a semicircle. The radius of the first grooves 72 is smaller than the radius of the cable 38. The bottom of the first grooves 72 is located on the upper side with respect to the upper end of the third-b rear surface portion 70b, and the first grooves 72 do not overlap the third-b rear surface portion 70b.

The open portion 60c is opened in the direction in which the first grooves 72 extend and in the direction in which the first grooves 72 are opened which is opposite to the direction in which the first grooves 72 are recessed. That is, the first grooves 72 extend in the forward and rearward direction, are recessed downward, and open upward. The first grooves 72 extend in a direction orthogonal to the third-a rear surface portion 60b of the third-a cover portion 60, and the first grooves 72 open toward the upper surface portion 60a. Therefore, by removing the third-a cover portion 60 from the third-b cover portion 70, the rear side (direction in which the first grooves 72 extend) is opened by the third-a rear surface portion 60b, and the upper side (direction in which the first grooves 72 open) is opened by the upper surface portion 60a. Thereby, the cable 38 can be easily fitted into the first grooves 72 from the open portion 60c.

The second seal portion 61 is provided with second grooves 62 into which the cable 38 of the electric component is fitted. The plurality of second grooves 62 are arranged in the rightward and leftward direction at intervals from each other along the lower end of the second seal portion 61. The second grooves 62 are recessed upward from the lower end of the second seal portion 61. The second grooves 62 extend in the thickness direction (forward and rearward direction) of the second seal portion 61 and penetrate the second seal portion 61.

The second grooves 62 have a circular arc shape in a plane perpendicular to the forward and rearward direction. As will be described later, when the first seal portion 71 and the second seal portion 61 are compressed with each other, the central angle of the circular arc shape of the second grooves 62 is set so that the first grooves 72 and the second grooves 62 form circular shapes. The radius of the second grooves 62 is smaller than the radius of the cable 38. The bottom of the second grooves 62 is located on the lower side with respect to the lower end of the third-a rear surface portion 60b, and the second grooves 62 do not overlap the third-a rear surface portion 60b.

The second grooves 62 are arranged at positions corresponding to the first grooves 72 in the upward and downward direction in a state where the third-a cover portion 60 (lid) covers the open portion 60c of the third-b cover portion 70 (body). Accordingly, openings are formed by the first grooves 72 and the second grooves 62 in the housing formed by the body and the lid. The openings are arranged to face the insertion portion 48 of the housing in the inner and outer directions of the housing. Therefore, the cable 38 can extend from the inside of the housing to the outside through the openings and the insertion portion 48.

A first outer support portion 73 is stacked outside the first seal portion 71, and a second outer support portion 63 is stacked outside the second seal portion 61. The first outer support portion 73 is harder than the first seal portion 71, and is formed of an elastic member such as rubber harder than the first seal portion 71, for example. The second outer support portion 63 is harder than the second seal portion 61, and is formed of an elastic member such as rubber harder than the second seal portion 61, for example.

The first outer support portion 73 is arranged between the first seal portion 71 and the third-b rear surface portion 70b and is fixed to these. The upper end of the first outer support portion 73 is located on the upper side with respect to the upper end of the third-b rear surface portion 70b, and is exposed to the outside of the third-b rear surface portion 70b. Further, the upper end of the first outer support portion 73 is located on the lower side with respect to the upper end of the first seal portion 71, and the upper portion of the first seal portion 71 protrudes upward from the first outer support portion 73.

The second outer support portion 63 is arranged between the second seal portion 61 and the third-a rear surface portion 60b and is fixed to these. The lower end of the second outer support portion 63 is located on the lower side with respect to the lower end of the third-a rear surface portion 60b, and is exposed to the outside of the third-a rear surface portion 60b. Further, the lower end of the second outer support portion 63 is located on the upper side with respect to the lower end of the second seal portion 61, and the lower portion of the second seal portion 61 protrudes downward from the second outer support portion 63.

The thickness in the forward and rearward direction of the first outer support portion 73 is equal to the thickness in the forward and rearward direction of the second outer support portion 63, and the width in the rightward and leftward direction of the first outer support portion 73 is equal to the width in the rightward and leftward direction of the second outer support portion 63. When the third-a cover portion 60 is attached to the third-b cover portion 70, the first outer support portion 73 and the second outer support portion 63 are arranged so that the upper end of the first outer support portion 73 and the lower end of the second outer support portion 63 face each other.

The first outer support portion 73 is provided with first outer grooves 74 into which the cable 38 of the electric component is fitted. The plurality of first outer grooves 74 are arranged in the rightward and leftward direction at intervals from each other along the upper end of the first outer support portion 73. The first outer grooves 74 are recessed from the open portion 60c of the third-b cover portion 70 and extend downward from the upper end of the first outer support portion 73. The first outer grooves 74 extend in the thickness direction (forward and rearward direction) of the first outer support portion 73 and penetrate the first outer support portion 73. The first outer grooves 74 have a circular arc shape in a plane perpendicular to the forward and rearward direction, and have, for example, a semicircular shape whose central angle is 180 degrees. The radius of the first outer grooves 74 is equal to or slightly larger than the radius of the cable 38. Further, the first outer grooves 74 have a radius larger than that of the first grooves 72 and are arranged so as to surround the first grooves 72. The bottom of the first outer grooves 74 is located on the upper side with respect to the third-b rear surface portion 70b, and the first outer grooves 74 do not overlap the third-b rear surface portion 70b.

The second outer support portion 63 is provided with second outer grooves 64 into which the cable 38 of the electric component is fitted. The plurality of second outer grooves 64 are arranged in the rightward and leftward direction at intervals from each other along the upper end of the second outer support portion 63. The second outer grooves 64 are recessed upward from the lower end of the second outer support portion 63. The second outer grooves 64 extend in the thickness direction (forward and rearward direction) of the second outer support portion 63 and penetrate the second outer support portion 63. The second outer grooves 64 have a circular arc shape in a plane perpendicular to the forward and rearward direction, and have, for example, a semicircular shape whose central angle is 180 degrees. The radius of the second outer grooves 64 is equal to or slightly larger than the radius of the cable 38. Further, the second outer grooves 64 have a radius larger than that of the second grooves 62 and are arranged so as to surround the second grooves 62. The bottom of the second outer grooves 64 is located on the lower side with respect to the third-a rear surface portion 60b, and the second outer grooves 64 do not overlap the third-a rear surface portion 60b.

A first inner support portion 75 is stacked inside the first seal portion 71, and a second inner support portion 65 is stacked inside the second seal portion 61. The first inner support portion 75 is harder than the first seal portion 71, and is formed of, for example, metal and resin. The second inner support portion 65 is harder than the second seal portion 61 and is made of, for example, metal and resin.

The first inner support portion 75 is arranged so as to sandwich the first seal portion 71 between the first inner support portion 75 and the first outer support portion 73 and is fixed to the third-b rear surface portion 70b together with these. The first inner support portion 75 has, for example, the same shape as the first outer support portion 73, and the upper end thereof is located on the upper side with respect to the upper end of the third-b rear surface portion 70b. Further, the upper end of the first inner support portion 75 is located on the lower side with respect to the upper end of the first seal portion 71, and the upper portion of the first seal portion 71 protrudes upward from the first inner support portion 75.

The second inner support portion 65 is arranged so as to sandwich the second seal portion 61 between the second inner support portion 65 and the second outer support portion 63 and is fixed to the third-a rear surface portion 60b together with these. The second inner support portion 65 has, for example, the same shape as the second outer support portion 63, and the lower end thereof is located on the lower side with respect to the lower end of the third-a rear surface portion 60b. Further, the lower end of the second inner support portion 65 is located on the upper side with respect to the lower end of the second seal portion 61, and the lower portion of the second seal portion 61 protrudes downward from the second inner support portion 65.

The first inner support portion 75 is provided with first inner grooves 76 into which the cable 38 of the electric component is fitted. The plurality of first inner grooves 76 are arranged in the rightward and leftward direction at intervals from each other along the upper end of the first inner support portion 75. The first inner grooves 76 are recessed from the open portion 60c of the third-b cover portion 70 and extend downward from the upper end of the first inner support portion 75. The first inner grooves 76 extend in the thickness direction (forward and rearward direction) of the first inner support portion 75 and penetrate the first inner support portion 75. The first inner grooves 76 have a circular arc shape in a plane perpendicular to the forward and rearward direction, and have, for example, a semicircular shape whose central angle is 180 degrees.

The radius of the first inner grooves 76 may be slightly larger than the radius of the cable 38 and may be larger than the radius of the first outer grooves 74. Further, the first inner grooves 76 have a radius larger than that of the first grooves 72 and are arranged so as to surround the first grooves 72. Thus, the first outer grooves 74, the first grooves 72, and the first inner grooves 76 are arranged in this order in the longitudinal direction (forward and rearward direction) of the cable 38, and thereby the inner side and the outer side of the third-b cover portion 70 communicate with each other. Further, the bottom of the first inner grooves 76 is located on the upper side with respect to the third-b rear surface portion 70b, and the first inner grooves 76 do not overlap the third-b rear surface portion 70b.

The second inner support portion 65 is provided with second inner grooves 66 into which the cable 38 of the electric component is fitted. The plurality of second inner grooves 66 are arranged in the rightward and leftward directions at intervals from each other along the upper end of the second inner support portion 65. The second inner grooves 66 are recessed upward from the lower end of the second inner support portion 65. The second inner grooves 66 extend in the thickness direction (forward and rearward direction) of the second inner support portion 65 and penetrate the second inner support portion 65. The second inner grooves 66 have a circular arc shape in a plane perpendicular to the forward and rearward direction, and have, for example, a semicircular shape whose central angle is 180 degrees.

The radius of the second inner grooves 66 is equal to or slightly larger than the radius of the cable 38. Further, the second inner grooves 66 have a radius larger than that of the second grooves 62 and are arranged so as to surround the second grooves 62. Thus, the second outer grooves 64, the second grooves 62, and the second inner grooves 66 are arranged in this order in the longitudinal direction (forward and rearward direction) of the cable 38, and thereby the inner side and the outer side of the third-a cover portion 60 communicate with each other. Further, the bottom of the second inner grooves 66 is located on the lower side with respect to the third-a rear surface portion 60b, and the second inner grooves 66 do not overlap the third-a rear surface portion 60b.

Next, how to attach the third cover 41 to the case 20 will be described with reference to Figs. 3 to 6. First, as shown in Fig. 4, the first cover 39, the second cover 40, and the third-b cover portion 70 of the third cover 41 are attached to the case 20 with screws or the like. Then, the cable 38 of the electric component in the case 20 is pulled out from the through hole 27 in the rear wall 23 to the third-b cover portion 70.

Then, as shown in Fig. 5, the cable 38 is fitted into the first groove 72 of the first seal portion 71 from the open portion 60c of the third-b cover portion 70. As a result, the cable 38 is positioned and supported by the first seal portion 71. For this reason, it is not necessary to hold the position of the cable 38.

At this time, since the radius of the first groove 72 is smaller than the radius of the cable 38 and the first seal portion 71 is formed of a soft elastic member, the first seal portion 71 is deformed by the cable 38. Then, the first seal portion 71 compressed by the cable 38 is in close contact with the cable 38 and the space therebetween is sealed.

The first grooves 72 are formed in a circular arc shape whose central angle is larger than 180 degrees. For this reason, the length of the opening of the first grooves 72 is smaller than the radius of the cable 38 in the rightward and leftward direction. For this reason, the cable 38 fitted in the first groove 72 is difficult to be removed from the opening of the first groove 72, and the cable 38 is securely held by the first groove 72.

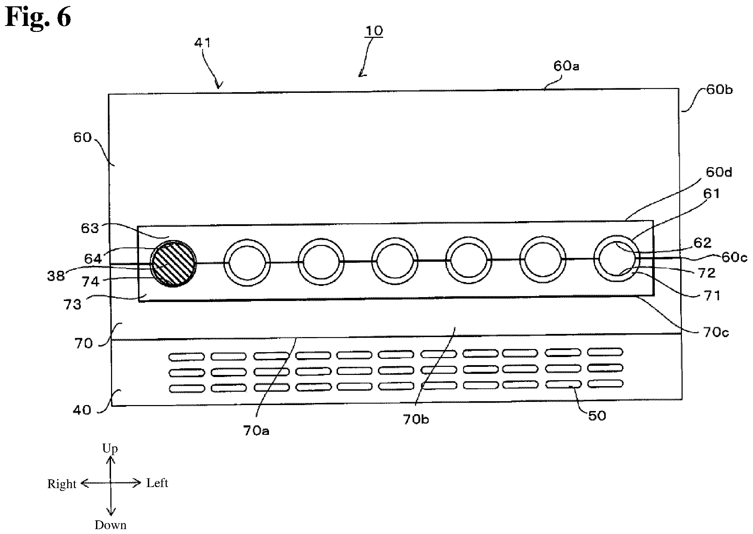

Subsequently, as shown in Figs. 3 and 6, when the third-a cover portion 60 is attached to the third-b cover portion 70, the first seal portion 71 protrudes upward from the first outer support portion 73, and the second seal portion 61 protrudes downward from the second outer support portion 63. Therefore, the first seal portion 71 and the second seal portion 61 come into contact with each other before the first outer support portion 73 and the second outer support portion 63 come into contact with each other. The first seal portion 71 and the second seal portion 61 formed of a soft elastic member are deformed and compressed against each other. As a result, the gaps of the first seal portion 71 and the second seal portion 61 themselves, which are formed of sponge, and the gap between the first seal portion 71 and the second seal portion 61 are filled, so that the space therebetween is more securely sealed.

Further, the first grooves 72 and the second grooves 62 are arranged to face each other in the upward and downward direction. Thus, when the second seal portion 61 is overlaid on the first seal portion 71, the upper portion of the cable 38 whose lower portion is fitted in the first groove 72 is fitted in the second groove 62. By compressing the first seal portion 71 and the second seal portion 61 against each other, the first grooves 72 and the second grooves 62 become circular, and the first seal portion 71 and the second seal portion 61 can be evenly in close contact with the cable 38. For this reason, the space therebetween is more securely sealed.

Further, the first seal portion 71 is sandwiched between the first outer support portion 73 and the first inner support portion 75. For this reason, when the first seal portion 71 is pushed by the cable 38, the first seal portion 71 is prevented from falling in the longitudinal direction of the cable 38. Further, when the first seal portion 71 is deformed by the cable 38, the first sieble is prevented from spreading in the longitudinal direction of the cable 38. As a result, the first seal portion 71 is compressed in the radial direction orthogonal to the longitudinal direction of the cable 38, and gap of the first seal portion 71 itself and the gap between the first seal portion 71 and the cable 38 are more securely sealed.

Similarly, the second seal portion 61 is sandwiched between the second outer support portion 63 and the second inner support portion 65. For this reason, when the second seal portion 61 is pushed by the cable 38, the second seal portion 61 is prevented from falling in the longitudinal direction of the cable 38. Further, when the second seal portion 61 is deformed by the cable 38, the second sieble is prevented from spreading in the longitudinal direction of the cable 38. As a result, the second seal portion 61 is compressed in the radial direction orthogonal to the longitudinal direction of the cable 38, and gap of the second seal portion 61 itself and the gap between the second seal portion 61 and the cable 38 are more securely sealed.

Subsequently, the upper end of the first outer support portion 73 and the lower end of the second outer support portion 63 come into contact with each other, and the space therebetween is closed. Thereby, the space therebetween is sealed. The third-a rear surface portion 60b and the third-b rear surface portion 70b are flush with each other to form the rear surface portion of the third cover 41.

The first outer support portion 73 and the second outer support portion 63 are harder than the first seal portion 71 and the second seal portion 61 and are exposed to the outside of the first seal portion 71 and the second seal portion 61. For this reason, the first outer support portion 73 and the second outer support portion 63 can prevent foreign matters such as wires from entering the third cover 41 from the outside.

Further, the cable 38 attached to the third cover 41 is hardly moved because it is covered by the case 20 and the third cover 41 on the inner side with respect to the first inner support portion 75 and the second inner support portion 65. For this reason, the cable 38 is unlikely to move to hit and damage the first inner support portion 75 and the second inner support portion 65. Therefore, although the electric device 10 has strength sufficient to support the first seal portion 71 and the second seal portion 61, an inexpensive material can be used for the first inner support portion 75 and the second inner support portion 65, so that cost of the electric device 10 can be reduced.

On the other hand, since the portion of the cable 38 outside the first outer support portion 73 and the second outer support portion 63 is exposed to the outside, the movement of the cable 38 is large. For this reason, the cable 38 is likely to move to hit and damage the first outer support portion 73 and the second outer support portion 63. However, since the first outer support portion 73 and the second outer support portion 63 are formed of an elastic member, the movement of the cable 38 can be suppressed. In addition, even when the cable 38 hits the first outer support portion 73 and the second outer support portion 63, the first outer support portion 73 and the second outer support portion 63 are unlikely to be deformed to damage the cable 38.

According to such a configuration, the electric device 10 includes the case 20 and the third-b cover portion 70 (body) that accommodate the electric components, the third-a cover portion 60 (lid) that covers the open portion 60c of the third-b cover portion 70, the first seal portion 71 provided on the third-b cover portion 70, the first grooves 72 which are formed in the first seal portion 71 so as to be recessed from the open portion 60c and into which the cable 38 of the electric component is fitted, the second seal portion 61 provided on the third-a cover portion 60, and the second grooves 62 which are formed in the second seal portion 61 so as to face the first grooves 72 and into which the cable 38 of the electric component is fitted.

According to this, the cable 38 is fitted into the first groove 72 and the second groove 62 facing each other, so that the cable 38 is positioned and supported. For this reason, by simply attaching the third-a cover portion 60 to the third-b cover portion 70, the spaces between the cable 38 and the third-b cover portion 70 and the third-a cover portion 60 can be more easily sealed by the first seal portion 71 and the second seal portion 61.

The first grooves 72 are formed in an arc shape whose central angle is larger than 180 degrees and radius is smaller than that of the cable 38. As a result, the cable 38 fitted in the first groove 72 comes into close contact with the first seal portion 71, and the space therebetween is sealed. Further, the cable 38 is unlikely to be removed from the first groove 72, and the cable 38 can be easily held.

Further, the first seal portion 71 and the second seal portion 61 are formed of an elastic member, and are compressed against each other when the open portion 60c is covered by the third-a cover portion 60. As a result, the gap of the first seal portion 71 itself, the gap of the second seal portion 61 itself, and the gap between the first seal portion 71 and the second seal portion 61 are filled, and the sealing performance thereof is secured.

Further, the first grooves 72 and the second grooves 62 form circular shapes by the compressed first seal portion 71 and second seal portion 61. Thereby, the first seal portion 71 and the second seal portion 61 are evenly in close with the cable 38 fitted in the first groove 72 and the second groove 62, and this sealing performance is secured.

Further, the electric device 10 includes the first outer support portion 73 that is stacked on the outer side with respect to the first seal portion 71 and harder than the first seal portion 71, and the first outer grooves 74 provided in the first outer support portion 73 so as to surround the first grooves 72. The electric device 10 includes the second outer support portion 63 that is stacked on the outer side with respect to the second seal portion 61 and harder than the second seal portion 61, and the second outer grooves 64 provided in the second outer support portion 63 so as to surround the second grooves 62. The first outer support portion 73 and the second outer support portion 63 exposed to the outside can prevent foreign matters from entering the third-b cover portion 70 from the outside. Further, the first outer support portion 73 and the second outer support portion 63 can support the cable 38 fitted in the first outer groove 74 and the second outer groove 64 without damaging it.

The electric device 10 further includes the first outer support portion 73 that is stacked on the outer side with respect to the first seal portion 71 and is harder than the first seal portion 71, the first outer grooves 74 provided in the first outer support portion 73 so as to surround the first grooves 72, the first inner support portion 75 that is stacked on the inner side with respect to the first seal portion 71 and is harder than the first seal portion 71, and the first inner grooves 76 provided in the first inner support portion 75 so as to surround the first grooves 72. The electric device 10 further includes the second outer support portion 63 that is stacked on the outer side with respect to the second seal portion 61 and is harder than the second seal portion 61, the second outer grooves 64 provided in the second outer support portion 63 so as to surround the second grooves 62, the second inner support portion 65 that is stacked on the inner side with respect to the second seal portion 61 and is harder than the second seal portion 61, and the second inner grooves 66 provided in the second inner support portion 65 so as to surround the second grooves 62. As a result, the first seal portion 71 is sandwiched between the first outer support portion 73 and the first inner support portion 75, so that the first seal portion 71 is prevented from tilting or expanding in the inner and outer directions. The second seal portion 61 is sandwiched between the second outer support portion 63 and the second inner support portion 65, so that the second seal portion 61 is prevented from tilting or expanding in the inner and outer directions. For this reason, the first seal portion 71 and the second seal portion 61 extend in the radial direction of the cable 38 to be in close contact with the cable 38, thereby being capable of sealing the spaces therebetween.

Furthermore, the plurality of first grooves 72 are provided side by side in the first seal portion 71, and the plurality of second grooves 62 are provided side by side in the second seal portion 61. Thus, by simply fitting the plurality of cables 38 into the plurality of first grooves 72 and the second grooves 62 so as to attach the third-a cover portion 60 to the third-b cover portion 70, the plurality of cables 38 are easily attached while securing sealing.

### (Other embodiments)

The present invention is not limited to the embodiments described with reference to the above description and drawings. For example, the following embodiments may also be included in the technical scope of the present invention.

Note that all the above embodiments may be combined with each other as long as they do not exclude each other. Based on the foregoing description, it is apparent for a person skilled in the art that many modifications and other embodiments may be made to the present invention. Therefore, the foregoing description should be interpreted only as an example and is provided for the purpose of teaching the best mode for carrying out the present invention to a person skilled in the art. The structures and/or functional details may be substantially modified without departing from the spirit of the present invention.

### Industrial Applicability

The electric device of the present invention is useful as an electric device that can easily secure sealing performance.

### Reference Signs List

- 10: electric device
- 20: case (body)
- 38: cable
- 48: insertion portion
- 60: third-a cover portion (lid)
- 61: second seal portion
- 60c: open portion
- 62: second groove
- 63: second outer support portion
- 64: second outer groove
- 65: second inner support portion
- 66: second inner groove
- 70: third-b cover portion (body)
- 71: first seal portion
- 72: first groove
- 73: first outer support portion
- 74: first outer groove
- 75: first inner support portion
- 76: first inner groove

## Claims

1. An electric device comprising:
a body that accommodates an electric component;
a lid that covers an open portion of the body;
a first seal portion provided on the body;
a second seal portion provided on the lid,
wherein a first groove which is recessed from the open portion and into which a cable of the electric component is fitted is formed in the first seal portion,
wherein a second groove which faces the first groove and into which the cable is fitted is formed in the second seal portion, and
wherein a housing formed by the body and the lid is provided with an insertion portion through which the cable of the electric component extending from an inside of the housing to an outside passes and which corresponds to the first groove and the second groove.

2. The electric device according to claim 1, wherein the insertion portion is formed by the body and the lid that covers the open portion.

3. The electric device according to claim 1 or 2, wherein the first groove is formed in an arc shape whose central angle is larger than 180 degrees and radius is smaller than a radius of the cable.

4. The electric device according to any one of claims 1 to 3, wherein the first seal portion and the second seal portion are formed of an elastic member, and are compressed against each other when the open portion is covered by the lid.

5. The electric device according to claim 4, wherein the first groove and the second groove form a circular shape by the first seal portion and the second seal portion compressed against each other.

6. The electric device according to any one of claims 1 to 5, further comprising:
a first outer support portion in which a first outer groove that surrounds the first groove is formed and which is stacked on an outer side with respect to the first seal portion and is harder than the first seal portion; and
a second outer support portion in which a second outer groove that surrounds the second groove is formed and which is stacked on an outer side with respect to the second seal portion and is harder than the second seal portion.

7. The electric device according to claim 6, further comprising:
a first inner support portion in which a first inner groove that surrounds the first groove is formed and which is stacked on an inner side with respect to the first seal portion and is harder than the first seal portion; and
a second inner support portion in which a second inner groove that surrounds the second groove is formed and which is stacked on an inner side with respect to the second seal portion and is harder than the second seal portion.

8. The electric device according to any one of claims 1 to 7, wherein the open portion is opened in a direction in which the first groove extends and in a direction in which the first groove is opened which is opposite to a direction in which the first groove is recessed.

9. The electric device according to any one of claims 1 to 8, wherein a plurality of first grooves are provided side by side in one first seal portion along a boundary between the body and the lid, and a plurality of second grooves face the first grooves and are provided side by side in the second seal portion.
